# EUROPEAN PATENT APPLICATION

(11) **EP 4 598 286 A1**
(43) Date of publication of application: **06.08.2025**
(21) Application number: 23872292.0
(22) Date of filing: 26.09.2023
(51) Int. Cl.: H05K 3/28, H01L 21/56, H05K 1/02

(54) **WIRING BOARD AND PACKAGE STRUCTURE USING SAME**

(30) Priority: 28.09.2022 JP 2022155322
(71) Applicant: Kyocera Corporation, Kyoto-shi, Kyoto 612-8501 (JP)
(72) Inventor: TANSHO, Asaka, Kyoto-shi, Kyoto 612-8501 (JP)
(74) Representative: Viering, Jentschura & Partner mbB Patent- und Rechtsanwälte
(86) International application number: PCT/JP2023/034821
(87) International publication number: WO 2024/071069

(57) **Abstract**

A wiring board according to the present disclosure includes an insulation substrate having a first surface and a second surface located opposite to the first surface, and a solder resist located on the first surface. The insulation substrate includes at least one recessed portion recessed from a peripheral edge toward a center of the insulation substrate in a plan view, and a plurality of electrodes located on the first surface along the recessed portion. The solder resist has an opening through which the electrode is exposed. The peripheral edge of the solder resist includes a first peripheral edge along the recessed portion and a second peripheral edge along a peripheral edge of the insulation substrate other than the recessed portion. The first peripheral edge overlaps with the peripheral edge of the recessed portion, and the second peripheral edge includes a first region connected to the first peripheral edge. In a plan view, the first region is located closer to the center of the insulation substrate than the peripheral edge of the insulation substrate.

## Description

### TECHNICAL FIELD

The present disclosure relates to a wiring board and a mounting structure using the same.

### BACKGROUND OF INVENTION

As the wiring board, for example, in an existing wiring board, a processor die is mounted on an upper surface and an optical module connected to an optical connector is mounted on an outer peripheral portion (Patent Documents 1 and 2). The optical module includes a photonics die.

After the optical module is mounted on the wiring board, an underfill (sealing resin) is filled between the photonics die and the wiring board. A part of the filled underfill (sealing resin) protrudes to the outer peripheral side surface of the substrate, and a connection failure with the optical connector may occur. In particular, the protrusion of the underfill (sealing resin) is likely to occur when the edge of the solder resist located on the upper surface of the wiring board is missing. The outer peripheral edge of the wiring board is likely to receive an impact during transportation or the like, and the edge of the relatively brittle solder resist is likely to be chipped by the impact.

### CITATION LIST

### PATENT LITERATURE

Patent Document 1: JP 2005-286225 A
Patent Document 2: JP 2009-536362 T

### SUMMARY

### SOLUTION TO PROBLEM

A wiring board according to the present disclosure includes an insulation substrate having a first surface and a second surface located opposite to the first surface, and a solder resist located on the first surface. The insulation substrate includes at least one recessed portion recessed from a peripheral edge toward a center of the insulation substrate in a plan view, and a plurality of electrodes located on the first surface along the recessed portion. The solder resist has an opening through which the electrode is exposed. The peripheral edge of the solder resist includes a first peripheral edge along the recessed portion and a second peripheral edge along a peripheral edge of the insulation substrate other than the recessed portion. The first peripheral edge overlaps with the peripheral edge of the recessed portion, and the second peripheral edge includes a first region connected to the first peripheral edge. In a plan view, the first region is located closer to the center of the insulation substrate than the peripheral edge of the insulation substrate.

A mounting structure according to the present disclosure includes the above-described wiring board, an adapter located in the recessed portion, and an electronic component connected to the adapter and the plurality of electrodes located on the first surface of the insulation substrate, wherein a sealing resin is located between a lower surface of the electronic component and the solder resist.

### BRIEF DESCRIPTION OF THE DRAWINGS

FIG. 1 is an explanatory diagram illustrating a mounting structure including a wiring board according to an embodiment of the present disclosure.
FIG. 2 is an explanatory diagram illustrating a wiring board according to an embodiment of the present disclosure.
FIG. 3 is a plan view of a region X illustrated in FIG. 2.
FIG. 4 is an enlarged explanatory view illustrating a connection portion between an adapter and an optical connector in the mounting structure illustrated in FIG. 1.
FIG. 5 is an enlarged explanatory view illustrating a state of a sealing resin in a connection portion between the adapter and the optical connector in the mounting structure illustrated in FIG. 1.

### DESCRIPTION OF EMBODIMENTS

As described above, a part of the filled sealing resin may protrude to the outer peripheral side surface of the substrate, and a connection failure with the optical connector may occur. Therefore, a demand for a wiring board and a mounting structure using the same that can suppress the filled sealing resin from protruding to the outer peripheral side surface of the wiring board is present even if a part of the sealing resin protrudes.

Since the wiring board and the mounting structure according to the present disclosure have the configurations as described in the section of SOLUTION TO PROBLEM, even when a part of the filled sealing resin protrudes, the protrusion to the outer peripheral side surface of the wiring board can be suppressed.

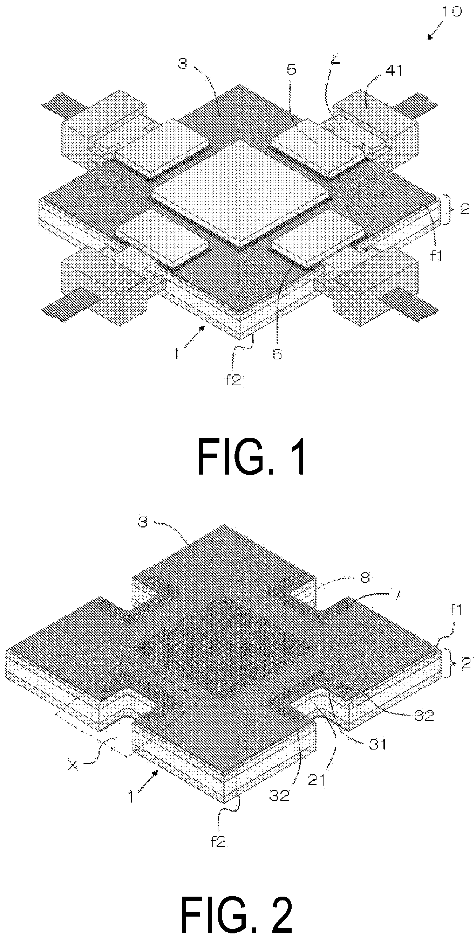

A wiring board according to an embodiment of the present disclosure will be described with reference to FIGs. 1 to 5. FIG. 1 is an explanatory diagram illustrating a mounting structure 10 including a wiring board 1 according to an embodiment of the present disclosure. FIG. 2 is an explanatory diagram illustrating the wiring board 1 according to the embodiment of the present disclosure. The wiring board 1 according to an embodiment includes an insulation substrate 2 and a solder resist 3.

The insulation substrate 2 has a first surface f1 and a second surface f2 located opposite to the first surface f1. Examples of the insulation layer constituting the insulation substrate 2 include a core insulation layer and a build-up insulation layer.

The build-up insulation layer is not particularly limited as long as it is a material having an insulating property. Examples of a material with insulation include resins such as epoxy resin, bismaleimide-triazine resin, polyimide resin, and polyphenylene ether resin. Two or more types of the resin may be mixed and used.

The build-up insulation layer may contain a reinforcing material. Examples of the reinforcing material include insulation fabric materials such as glass fibers, glass nonwoven fabrics, aramid nonwoven fabrics, aramid fibers, and polyester fibers. Two or more types of reinforcing materials may be used in combination. An inorganic insulating filler such as silica, barium sulfate, talc, clay, glass, calcium carbonate, or titanium oxide may be dispersed in the build-up insulation layer. Two or more types of inorganic insulating fillers may be used in combination.

In FIG. 2, the build-up insulation layers are located on the upper surface side and the lower surface side of the core insulation layer. The thickness of the build-up insulation layer is not particularly limited, and is, for example, 10 µm or more and 50 µm or less.

A via-hole conductor is located in the build-up insulation layer to electrically connect the upper and lower surfaces of the build-up insulation layer. The via-hole conductor is located in a via hole penetrating upper and lower surfaces of the build-up insulation layer. The via-hole conductor is made of, for example, a metal such as copper, specifically, metal plating such as copper plating. The via-hole conductor may be filled in the via hole or may be formed only on the inner wall surface of the via hole. The via-hole conductor is connected to the conductor layers located on the upper and lower surfaces of the build-up insulation layer.

The core insulation layer is also not particularly limited as long as it is made of an insulating material. Examples of the material having insulating properties include resins such as an epoxy resin, a bismaleimide-triazine resin, a polyimide resin, and a polyphenylene ether resin, as the same as and/or similar to the build-up insulation layer. As the same as and/or similar to the build-up insulation layer, a reinforcing material may be contained, and an inorganic insulating filler may be dispersed.

The core insulation layer is located substantially at the center in the thickness direction of the wiring board 1, and is usually thicker than the build-up insulation layer. The thickness of the core insulation layer is not particularly limited, and is, for example, 100 µm or more and 1500 µm or less.

A through-hole conductor is located in the core insulation layer in order to electrically connect the upper and lower surfaces of the core insulation layer. The through-hole conductor is located in a through hole penetrating through the upper and lower surfaces of the core insulation layer. The through-hole conductors are composed of, for example, a metal such as copper, specifically, metal plating such as copper plating. The through-hole conductor may be formed only on an inner wall surface of the through hole, or the through hole may be filled with the through hole conductor. The through-hole conductors are connected to the conductor layers located on the upper and lower surfaces of the core insulation layer.

The shape of the insulation substrate 2 is not limited. In a plan view, the insulation substrate 2 may have a quadrangular shape as illustrated in FIG. 2, or may have a polygonal shape other than the quadrangular shape, a circular shape, an elliptical shape, or the like. The insulation substrate 2 has a recessed portion 21 that is recessed from the peripheral edge of the insulation substrate 2 toward the center of the insulation substrate 2 in a plan view. The insulation substrate 2 includes at least one recessed portion 21. As illustrated in FIG. 2, when the insulation substrate 2 has a quadrangular shape, the recessed portion 21 is located so as to be recessed from one side (first side) of the sides constituting the quadrangular shape toward the center of the insulation substrate 2.

The size of the recessed portion 21 is appropriately set in accordance with the size of an adapter 4 located in the recessed portion 21. The insulation substrate 2 includes at least one recessed portion 21, and when the insulation substrate 2 has a polygonal shape such as a quadrangular shape, a plurality of recessed portions 21 may be included on one side.

A plurality of electrodes 8 are located along the recessed portion 21 at the first surface f1 of the insulation substrate 2. The first surface f1 of the insulation substrate 2 is an upper surface on the surface layer side in the thickness direction of the wiring board 1, and the second surface f2 is a lower surface located on the side opposite to the first surface f1 in the thickness direction of the wiring board 1. The electrodes 8 are made of metals such as copper, and are part of a conductive layer located on the first surface f1 of the insulation substrate 2. In the first surface f1 of the insulation substrate 2, the electrode 8 is located not only at a position along the recessed portion 21 but also, for example, at a substantially central portion of the insulation substrate 2 as illustrated in FIG. 2. A terminal of the processor die is connected to the electrode 8 in the central portion via the solder 7 described later.

As illustrated in FIG. 2, a solder resist 3 is located on the first surface f1 of insulation substrate 2. The solder resist 3 is made of a resin, and examples of the resin include an acrylic-modified epoxy resin. The solder resist 3 has a thickness of, for example, 10 µm or more and 50 µm or less.

The solder resist 3 has openings through which each electrode 8 is individually exposed. In FIG. 2, the solder 7 is attached to the electrode 8 exposed in the opening.

In a plan view, the solder resist 3 is formed in accordance with the shape of the insulation substrate 2. The peripheral edge of the solder resist 3 includes a first peripheral edge 31 along the recessed portion 21 of the insulation substrate 2 and a second peripheral edge 32 along the peripheral edge other than the recessed portion 21 of the insulation substrate 2. The first peripheral edge 31 of the solder resist 3 overlaps with the peripheral edge of the recessed portion 21 of the insulation substrate 2. That is, the side surface of the first peripheral edge 31 and the side surface of the recessed portion 21 are located to be substantially flush with each other.

Since the first peripheral edge 31 of the solder resist 3 overlaps with the peripheral edge of the recessed portion 21 of the insulation substrate 2, the width of the solder resist 3 can be sufficiently ensured. As a result, for example, the thermal influence on the wiring board 1 when an electronic component 5 described later is mounted is reduced. The gap between the lower surface of the electronic component 5 and the mounting region of the wiring board 1 (solder resist 3) becomes constant, and the filling property of the sealing resin 6 becomes uniform.

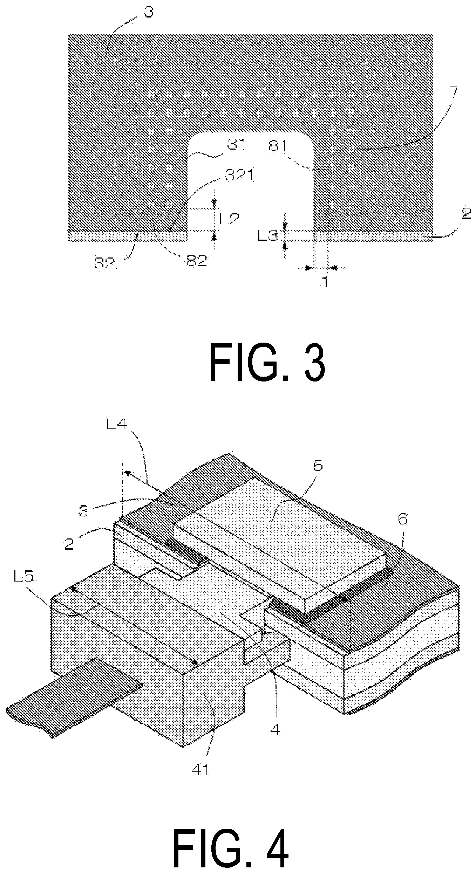

As illustrated in FIG. 3, the second peripheral edge 32 of the solder resist 3 includes a first region 321 connected to the first peripheral edge 31. In a plan view, the first region 321 is located closer to the center of the insulation substrate 2 than the peripheral edge of the insulation substrate 2 other than the recessed portion 21. FIG. 3 is a plan view of a region X illustrated in FIG. 2. As illustrated in FIG. 2, when the insulation substrate 2 has a quadrangular shape, the first region 321 of the second peripheral edge 32 is located closer to the center of the insulation substrate 2 than the first side of the insulation substrate 2. Since the first region 321 is located closer to the center of the insulation substrate 2 than the peripheral edge of the insulation substrate 2, for example, when the space between the wiring board 1 and the electronic component 5 is filled with the sealing resin 6, the overflowing sealing resin 6 are retained at the first surface f1 of the insulation substrate 2 exposed from the solder resist 3.

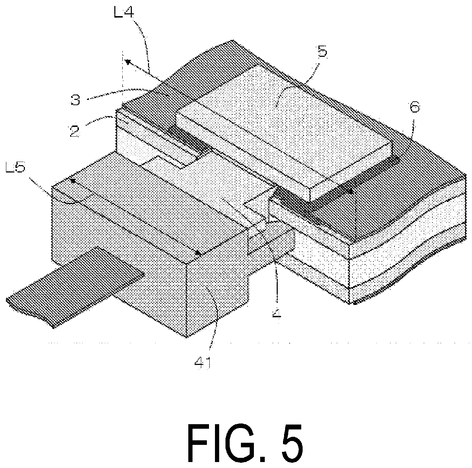

A step is formed between the peripheral edge (second peripheral edge 32) of the solder resist 3 and the peripheral edge of the insulation substrate 2. By forming such a step, as illustrated in FIG. 4, the sealing resin 6 is less likely to protrude to the outer peripheral side surface of the wiring board 1. Even if the sealing resin 6 flows to the step portion, as illustrated in FIG. 5, the sealing resin 6 flows along the step and hardly protrudes to the outer peripheral side surface of the wiring board 1. As a result, as illustrated in FIGs. 4 and 5, the optical connector 41 is favorably connected to the wiring board 1 via the adapter 4. FIGs. 4 and 5 are enlarged explanatory views illustrating a connection portion between the adapter 4 and the optical connector 41 in the mounting structure 10 illustrated in FIG. 1.

Since the solder resist 3 is relatively fragile, the peripheral edge is likely to be chipped or scratched. By positioning the second peripheral edge 32 in the central direction_of the insulation substrate 2, an impact generated during transportation or the like is less likely to be applied to the second peripheral edge 32. As a result, the second peripheral edge 32 of the solder resist 3 is less likely to be chipped or damaged. The chipping generated in the peripheral edge of the solder resist 3 serves as a starting point from which the sealing resin 6 flows out to the outer peripheral side surface of the wiring board 1. Therefore, reducing the occurrence of chipping is also advantageous in suppressing the sealing resin 6 from flowing out.

As long as the first region 321 is located closer to the center of the insulation substrate 2 than the peripheral edge of the insulation substrate 2, the length (third length L3) between the first region 321 and the peripheral edge of the insulation substrate 2 closest to the first region 321 is not limited. The third distance L3 may be, for example, from 50 µm to 500 µm.

The electrode 8 located on the first surface f1 of the insulation substrate 2 include a first electrode 81 located closest to the first peripheral edge 31 and a second electrode 82 located closest to the first region 321 of the second peripheral edge 32. In the wiring board 1 according to one embodiment, the distance (first distance L1) between the first peripheral edge 31 and the first electrode 81 may be shorter than the distance (second distance L2) between the first region 321 of the second peripheral edge 32 and the second electrode 82. To be specific, the first distance L1 may be from 100 µm to 400 µm, and the second distance L2 may be from 200 µm to 600 µm. When the first distance L1 is shorter than the second distance L2, the width of the recessed portion 21 is sufficiently secured while sufficiently maintaining the electrical insulating reliability between the plurality of electrodes 8 located along the recessed portion 21. A region where the sealing resin 6 can stay in the direction of the outer peripheral side surface of the wiring board 1 can be secured, further reducing the risk of the sealing resin 6 flowing out to the outer peripheral side surface.

The difference between the first distance L1 and the second distance L2 may be, for example, 100 µm or more. When the difference between the first distance L1 and the second distance L2 is 100 µm or more, the gap between the electronic components 5 and the wiring board 1 (solder resist 3) is more easily filled with the sealing resin 6. As a result, an improvement in the electrical insulating reliability between the plurality of electrodes 8 can be expected. The risk of the sealing resin 6 flowing out to the outer peripheral side surface of the wiring board 1 can be further reduced. The difference between the first distance L1 and the second distance L2 may be, for example, 200 µm or less.

The third distance L3 described above may be shorter than the first distance L1. By making the third distance L3 shorter than the first distance L1, it becomes easy to sufficiently fill the sealing resin 6 between the plurality of electrodes 8 located along the recessed portion 21, and the electrical insulating reliability is improved. By making the third distance L3 shorter than the first distance L1, the exposed portion of the first surface f1 of the insulation substrate 2 is reduced, and the size of the wiring board 1 can be reduced.

The arithmetic average roughness of each of the first surface f1 of the insulation substrate 2 and the surfaces of the solder resist 3 is not limited. For example, the arithmetic average roughness of the first surface f1 of the insulation substrate 2 exposed along the second peripheral edge 32 may be greater than the arithmetic average roughness of the solder resist 3. To be specific, the arithmetic average roughness of the surfaces of the solder resist 3 may be from 200 nm to 400 nm. The arithmetic average roughness of the first surface f1 of the insulation substrate 2 exposed along the second peripheral edge 32 may be from 500 nm to 800 nm. The arithmetic average roughness can be measured by, for example, a laser microscope.

When the arithmetic average roughness of the first surface f1 of the insulation substrate 2 exposed along the second peripheral edge 32 is greater than the arithmetic average roughness of the front face of the solder resist 3, wettability is sufficiently ensured on the front face of the solder resist 3. As a result, the sealing resin 6 is more easily filled. The wettability of the first surface f1 of the insulation substrate 2 exposed along the second peripheral edge 32 is improved. Therefore, for example, as illustrated in FIG. 5, even if the sealing resin 6 flows to the exposed first surface f1 of the insulation substrate 2, the sealing resin 6 easily spreads on the exposed first surface f1 along the corner portion between the end surface of the solder resist 3 and the exposed first surface f1. As a result, it becomes more difficult for the sealing resin 6 to protrude to the outer peripheral side surface of the wiring board 1.

A mounting structure according to the present disclosure will be described. As illustrated in FIG. 1, a mounting structure 10 according to an embodiment of the present disclosure includes the wiring board 1 according to the above-described embodiment, the adapter 4, the electronic component 5, the optical connector 41, and the sealing resin 6.

The adapter 4 is a member for connecting the optical connector 41 to the wiring board 1, and is located in the recessed portion 21 of the insulation substrate 2. In the direction along the peripheral edge of the insulation substrate 2, the width L4 of the first region 321 may be longer than the width L5 of the optical connector 41 in the direction along the first region 321. With such a configuration, the portion of the optical connector 41 facing the outer peripheral side surface of the wiring board 1 is accommodated in the first region 321. Since the first region 321 is located closer to the center of the wiring board 1 than the peripheral edge of the insulation substrate 2, the sealing resin 6 can be suppressed from flowing out to the outer peripheral side surface of the wiring board 1, and the connectivity between the optical connector 41 and the wiring board 1 can be improved.

The electronic component 5 is connected to the adapter 4 and the plurality of electrodes 8 located on the first surface f1 of the insulation substrate 2. Examples of the electronic component 5 include an optoelectronic element and an interface element. The sealing resin 6 is located between the lower surface of the electronic component 5 and the solder resist 3. The sealing resin 6 is used to fix the electronic component 5 to the wiring board 1. Examples of the sealing resin 6 include an epoxy resin, a polyimide resin, and a urethane resin.

An embodiment of the present disclosure has been described above. However, the invention according to the present disclosure is not limited to the above-described embodiment, and various modifications or improvements can be made within the scope of the present disclosure described in (1) and (7) below.
(1) A wiring board according to the present disclosure includes an insulation substrate having a first surface and a second surface located opposite to the first surface, and a solder resist located on the first surface. The insulation substrate includes at least one recessed portion recessed from a peripheral edge of the insulation substrate toward a center of the insulation substrate in a plan view, and a plurality of electrodes located on the first surface along the recessed portion. The solder resist has an opening through which the electrode is exposed. The peripheral edge of the solder resist includes a first peripheral edge along the recessed portion and a second peripheral edge along a peripheral edge of the insulation substrate other than the recessed portion. The first peripheral edge overlaps with the peripheral edge of the recessed portion, and the second peripheral edge includes a first region connected to the first peripheral edge. In a plan view, the first region is located closer to the center of the insulation substrate than the peripheral edge of the insulation substrate.
   With regard to embodiments of the present disclosure, the following embodiments (2) to (6) and (8) are further disclosed.
(2) In the wiring board according to (1), in a plan view, the insulation substrate includes a quadrangular shape including a first side, and the recessed portion is located to be recessed from the first side toward the center of the insulation substrate, and in a plan view, the first region of the second peripheral edge is located closer to the center of the insulation substrate than the first side.
(3) In the wiring board according to (1) or (2), an arithmetic average roughness of the first surface of the insulation substrate exposed along the second peripheral edge is greater than an arithmetic average roughness of a surface of the solder resist.
(4) In the wiring board according to any one of (1) to (3) , the plurality of electrodes includes a first electrode located closest to the first peripheral edge and a second electrode located closest to the first region of the second peripheral edge, and a first distance between the first peripheral edge and the first electrode is shorter than a second distance between the first region of the second peripheral edge and the second electrode.
(5) In the wiring board according to (4), a difference between the first distance and the second distance is 100 µm or more.
(6) In the wiring board according to (4) or (5), a third distance between the first region and a peripheral edge of the insulation substrate located closest to the first region is shorter than the first distance.
(7) A mounting structure according to the present disclosure includes the wiring board according to any one of (1) to (6), an adapter located in the recessed portion, and an electronic component connected to the adapter and the plurality of electrodes located on the first surface of the insulation substrate, wherein a sealing resin is located between a lower surface of the electronic component and the solder resist.
(8) In the mounting structure according to (7), the adapter is connected to an optical connector on a side opposite to the recessed portion, and in a direction along the peripheral edge of the insulation substrate, a width of the first region is larger than a width of a portion of the optical connector facing the first region.

### REFERENCE SIGNS

1 Wiring board
2 Insulation substrate
21 Recessed portion
3 Solder resist
31 First peripheral edge
32 Second peripheral edge
321 First region
4 Adapter
41 Optical connector
5 Electronic component
6 Sealing resin
7 Solder
8 Electrode
81 First electrode
82 Second electrode
10 Mounting structure
f1 First surface
f2 Second surface

## Claims

1. A wiring board comprising:
an insulation substrate comprising a first surface and a second surface located opposite to the first surface; and
a solder resist located on the first surface, wherein
the insulation substrate comprises at least one recessed portion that is recessed from a peripheral edge of the insulation substrate toward a center of the insulation substrate in a plan view, and a plurality of electrodes located on the first surface along the recessed portion,
the solder resist comprises an opening through which the electrodes are exposed,
the peripheral edge of the solder resist comprises a first peripheral edge along the recessed portion and a second peripheral edge along a peripheral edge of the insulation substrate other than the recessed portion,
the first peripheral edge overlaps with a peripheral edge of the recessed portion,
the second peripheral edge comprises a first region connected to the first peripheral edge, and
in a plan view, the first region is located closer to the center of the insulation substrate than the peripheral edge of the insulation substrate.

2. The wiring board according to claim 1, wherein
in a plan view, the insulation substrate comprises a quadrangular shape comprising a first side, and the recessed portion is located to be recessed from the first side toward the center of the insulation substrate, and
in a plan view, the first region of the second peripheral edge is located closer to the center of the insulation substrate than the first side.

3. The wiring board according to claim 1 or 2, wherein
an arithmetic average roughness of the first surface of the insulation substrate exposed along the second peripheral edge is greater than an arithmetic average roughness of a surface of the solder resist.

4. The wiring board according to any one of claims 1 to 3, wherein
the plurality of electrodes comprises a first electrode located closest to the first peripheral edge and a second electrode located closest to the first region of the second peripheral edge, and
a first distance between the first peripheral edge and the first electrode is shorter than a second distance between the first region of the second peripheral edge and the second electrode.

5. The wiring board according to claim 4, wherein
a difference between the first distance and the second distance is 100 µm or more.

6. The wiring board according to claim 4 or 5, wherein
a third distance between the first region and a peripheral edge of the insulation substrate located closest to the first region is shorter than the first distance.

7. A mounting structure comprising:
the wiring board according to any one of claims 1 to 6,
an adapter located in the recessed portion; and
an electronic component connected to the adapter and the plurality of electrodes located on the first surface of the insulation substrate, wherein
a sealing resin is located between a lower surface of the electronic component and the solder resist.

8. The mounting structure according to claim 7, wherein
the adapter is connected to an optical connector on a side opposite to the recessed portion, and
in a direction along the peripheral edge of the insulation substrate, a width of the first region is larger than a width of a portion of the optical connector facing the first region.
